# EUROPEAN PATENT APPLICATION

(11) **EP 4 814 731 A1**
(43) Date of publication of application: **30.09.2026**
(21) Application number: 26160851.7
(22) Date of filing: 26.02.2026
(51) Int. Cl.: G06F 13/16, G06F 13/40, H04L 49/101, H04L 49/109, G06F 13/10, H03K 19/17728, H03K 19/17736, H03K 19/1776, H03K 19/17796, G06F 30/343

(54) **TECHNIQUES FOR TRANSMITTING DATA THROUGH A NETWORK-ON-CHIP IN AN INTEGRATED CIRCUIT**

(30) Priority: 26.03.2025 US 202519091019
(71) Applicant: Altera Corporation, San Jose, CA 95134 (US)
(72) Inventor: Weber, Scott, San Jose, 95134 (US); Kumar, Rajiv, San Jose, 95134 (US); Shirvaikar, Tara, San Jose, 95134 (US)
(74) Representative: Hermann, Felix

(57) **Abstract**

An integrated circuit (100) includes memory circuits (103) in a central region of the integrated circuit, and a network-on-chip (102) that traverses the central region. The network-on-chip (102) includes a controller circuit (104) configurable to exchange data between first and second ones of the memory circuits through the network-on-chip (102) by transmitting the data from a source in the network-on-chip (102) to a sink in the network-on-chip (102). The network-on-chip (102) is configurable to place each of the source and the sink at one of multiple locations along the network-on-chip (102).

## Description

### BACKGROUND

Configurable integrated circuits can be configured by users to implement desired custom logic functions. In a typical scenario, a logic designer uses computer-aided design (CAD) tools to design a custom circuit design. When the design process is complete, the computer-aided design tools generate configuration data containing configuration bits. The configuration data is then loaded into configuration memory elements that configure configurable logic circuits in the integrated circuit to perform the functions of the custom circuit design. Configurable integrated circuits can be used for co-processing in big-data or fast-data applications. For example, configurable integrated circuits can be used in application acceleration tasks in a datacenter and can be reprogrammed during datacenter operation to perform different tasks.

### BRIEF DESCRIPTION OF DRAWINGS

Figure 1 is a diagram that depicts an example of an integrated circuit (IC) that includes micro network-on-chips (NOCs) in a fabric region of the IC.
Figure 2 is a diagram that illustrates an example of an embedded direct memory group that can be instantiated alongside one or more of the micro NOCs shown in Figure 1 that are embedded in fabric memory circuits.
Figure 3A is a diagram that illustrates an example of a micro NOC ingress interface circuit that is mapped to an interface for a fabric memory.
Figure 3B is a diagram that illustrates an example of a micro NOC egress interface circuit that is mapped to an interface for a fabric memory.
Figure 4 is a diagram that illustrates an example of a micro NOC that is configured as a micro NOC direct coupling.
Figure 5 is a diagram that illustrates an example of two integrated circuit (IC) dies that are coupled together through conductors in an interface.
Figure 6 is a diagram that illustrates an example of a micro NOC in an integrated circuit (IC) that allows a user to create a system of switches on top of a micro NOC column in a switch mode.
Figure 7 is a diagram that illustrates an example of a micro NOC controller circuit in a micro NOC that is configured to read data from a fabric memory circuit and to send the data along a north-bound micro NOC bus in the micro NOC.
Figure 8 is a diagram that illustrates an example of the micro NOC controller circuit in the micro NOC that is configured to read data from a fabric memory circuit and to send the data along a south-bound micro NOC bus in the micro NOC.
Figure 9 is a diagram that illustrates an example of the micro NOC controller circuit in the micro NOC that is configured to transmit write data from the south-bound micro NOC bus in the micro NOC to a fabric memory circuit.
Figure 10 is a diagram that illustrates an example of the micro NOC controller circuit in the micro NOC that is configured to transmit write data from the north-bound micro NOC bus in the micro NOC to a fabric memory circuit.
Figure 11 is a diagram that illustrates an example of the micro NOC controller circuit in the micro NOC that is configured to read data from a fabric memory circuit and to send the data along the north-bound micro NOC bus and/or along the south-bound micro NOC bus in the micro NOC.
Figure 12 is a diagram that illustrates an example of the micro NOC controller circuit in the micro NOC that is configured to transmit write data from the north-bound micro NOC bus and/or from the south-bound micro NOC bus in the micro NOC to a fabric memory circuit.
Figure 13 is a diagram of an illustrative example of a configurable integrated circuit (IC).
Figure 14 illustrates a block diagram of a system that can be used to implement a circuit design to be programmed into a programmable logic device using design software.
Figure 15 is a diagram that depicts an example of a programmable logic device that includes a fabric die and a base die that are connected to one another via microbumps.
Figure 16 is a block diagram illustrating a computing system configured to implement one or more aspects of the embodiments described herein.

### DETAILED DESCRIPTION

In some types of configurable integrated circuits (ICs), a bus is used to facilitate data movement between external memory devices and on-chip memory circuits. The bus is typically not configurable in numerous ways. For example, the bus does not allow direct data transfer between external memory devices and on-chip memory circuits or between on-chip memory circuits.

According to some examples disclosed herein, an integrated circuit (IC) is provided that includes a micro network-on-chip (i.e., micro NOC) in a central fabric region of the IC. The micro NOC functions as a standalone high-speed bus, while being disconnected from a response buffer circuit in the IC. As a result, the micro NOC enables a system of switches and a method for multicasting data transfer in the central fabric region. The micro NOC can enable the amount of fabric resources in the IC to be substantially reduced compared to previously known fabric routing solutions.

The micro NOC can include memory controller circuits that can be configured to enable multicasting data to fabric memory circuits in the IC having multiple different source identifiers, thus creating a high-speed switch system. The micro NOC increases available soft logic in the central fabric region of the IC. The micro NOC can move data at a higher speed than routing in the central fabric region from one fabric memory to another fabric memory in the IC. Thus, the micro NOC reduces the amount of fabric resources dedicated to routing, creates a technique for multicasting data vertically across the central fabric region, and creates a system of switches in the central fabric region, without any external control by a response buffer.

One or more specific examples are described below. In an effort to provide a concise description of these examples, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Throughout the specification, and in the claims, the term "connected" means a direct electrical connection between the circuits that are connected, without any intermediary devices. The term "coupled" means either a direct electrical connection between circuits or an indirect electrical connection through one or more passive or active intermediary devices that allows the transfer of information between circuits. The term "circuit" may mean one or more passive and/or active electrical components that are arranged to cooperate with one another to provide a desired function.

This disclosure discusses integrated circuit devices, including configurable (programmable) logic integrated circuits, such as field programmable gate arrays (FPGAs). As discussed herein, an integrated circuit (IC) can include hard logic and/or soft logic. The circuits in an integrated circuit device (e.g., in a configurable logic IC) that are configurable by an end user are referred to as "soft logic." "Hard logic" generally refers to circuits in an integrated circuit device that have substantially less configurable features than soft logic or no configurable features.

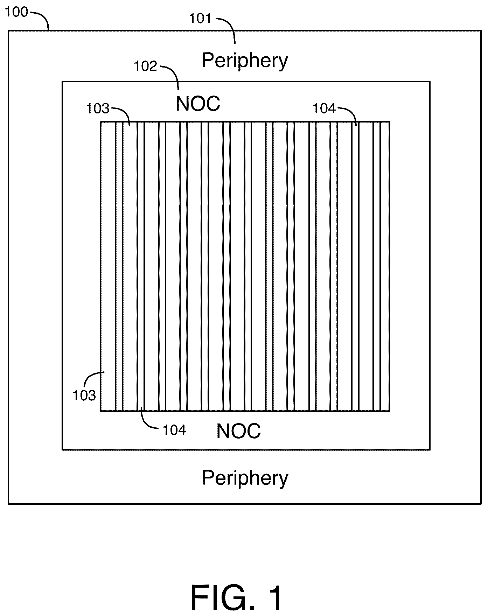

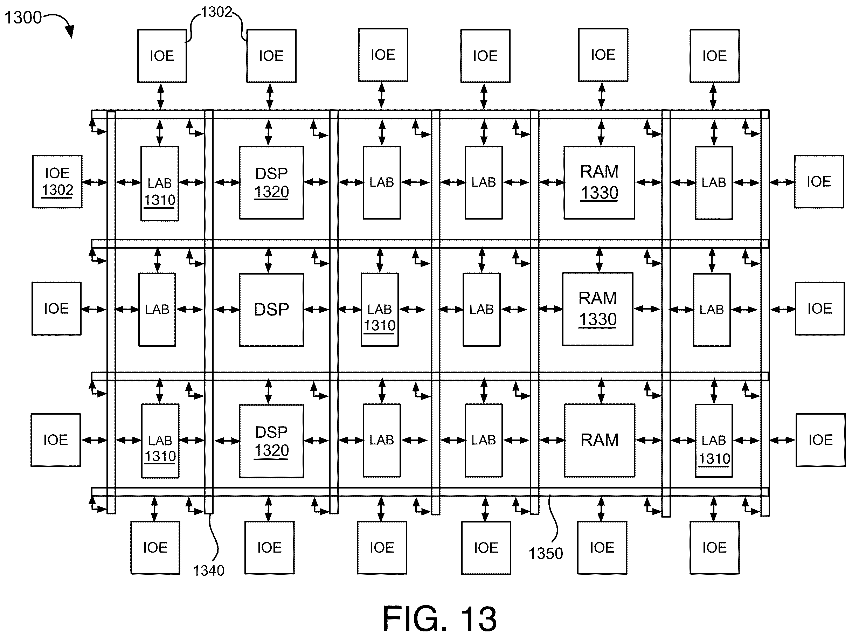

Figure 1 is a diagram that depicts an example of an integrated circuit (IC) 100 that includes micro network-on-chips (i.e., micro NOCs) 104 in a central fabric region 103 of the IC 100. The central fabric region 103 is also referred to herein as a central region or fabric region 103. Figure 1 shows 13 micro NOCs 104 as an example. According to various examples, ICs can include any number of the micro NOCs disclosed herein. The fabric region 103 includes soft logic and memory circuits that are not shown in Figure 1, but are shown, for example, in Figure 13. IC 100 also includes a periphery region 101 and a network-on-chip (NOC) 102 that surrounds the fabric region 103 and is inside the periphery region 101. The IC 100 of Figure (FIG.) 1 can be any type of integrated circuit (IC), such as a configurable IC (e.g., a field programmable gate array (FPGA) or programmable logic device), a microprocessor IC, a graphics processing unit IC, a memory IC, an application specific IC, a transceiver IC, a memory IC, etc.

The micro NOCs 104 are high-bandwidth hardened data paths between the NOC 102 and the fabric region 103. Each of the micro NOCs 104 extends across the entire length of the fabric region 103 as shown in FIG. 1. The micro NOCs 104 allow data traffic on the NOC 102 to be forwarded deep into the fabric region 103 by leveraging available routing tracks over fabric memory circuits (e.g., block random access memory or BRAM) along with the fabric memory circuits to couple an interface to collections of ports of the fabric memory circuits. The fabric memory circuits are used as shallow buffers that support micro NOCs 104 being utilized for hardened memory transport between external and on-chip memory circuits, effectively allowing each micro-NOC 104 to enable ubiquitous NOC ports. The micro NOCs 104 also support ubiquitous interface bridge creation throughout the fabric region 103, effectively allowing the BRAMs to be NOC-attached memory. This interface may be, for example, an Advanced Extensible Interface (AXI).

The micro NOCs 104 can be used to create micro NOC direct couplings that are disclosed in further detail below. The micro NOC direct couplings allow high-speed data transport through the fabric region 103 along a singular micro NOC 104 column for one or many initiators of data traffic. The micro NOCs 104 allow efficient use of resources in the fabric region 103 by avoiding routing congestion, because the micro NOCs 104 can operate at a higher frequency (e.g., twice the frequency) than the surrounding fabric region 103.

If a response buffer (RB) circuit is not involved in a micro NOC 104 column, or if there are partitions of a micro NOC 104 column that the RB circuit does not need to access (e.g., the user does not need the fabric memory circuits along the micro NOC 104 column to couple to peripheral or external memory circuits), that micro NOC 104 column can be repurposed into a high-speed data transport that vertically moves data around the fabric region 103. In addition to micro NOC direct couplings enabling high-speed data transport from one fabric memory circuit to another, the micro NOCs 104 enable a multicast mechanism, where one source can have multiple sinks along the micro NOC 104 column. The multicast mechanism can be created, as examples, in two ways. According to a first example, the fabric memory circuits are provided with the same identifier and a single SOP (start of packet) that activates the fabric memory circuits. According to a second example, a mechanism is provided where multicast groups are created dynamically by issuing multiple SOPs with the same source identifier to fabric memory circuits with different identifiers.

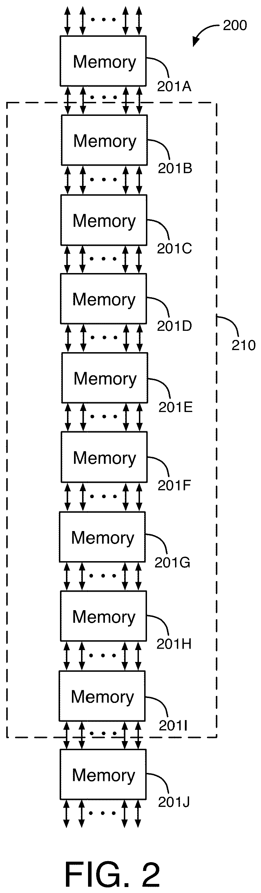

Figure 2 is a diagram that illustrates an example of a direct memory group 200 that can be instantiated alongside one or more of the micro NOCs 104 shown in FIG. 1. An instance of the direct memory group 200 of FIG. 2 can, as examples, be in one, some, or each of the micro NOCs 104 of FIG. 1. The direct memory group 200 includes 10 memory circuits 201A-201J that are coupled together through parallel conductors within the micro NOC. According to various examples, the direct memory group 200 can include any number of memory circuits 201 coupled together.

Each adjacent pair of the memory circuits 201A-201J are coupled together through a subset of the parallel conductors. Figure 2 also shows a mapping 210 of the micro NOC direct memory group 200 to fabric memory circuits (e.g., BRAM). In this embodiment, eight of the memory circuits 201B-201I are used for storing data and are mapped (shown by mapping 210) to fabric memory circuits (not shown). In other embodiments, the memory capacity of the mapping to the fabric memory circuits can be increased by including additional memory circuits 201 or decreased by removing one or more of the memory circuits 201.

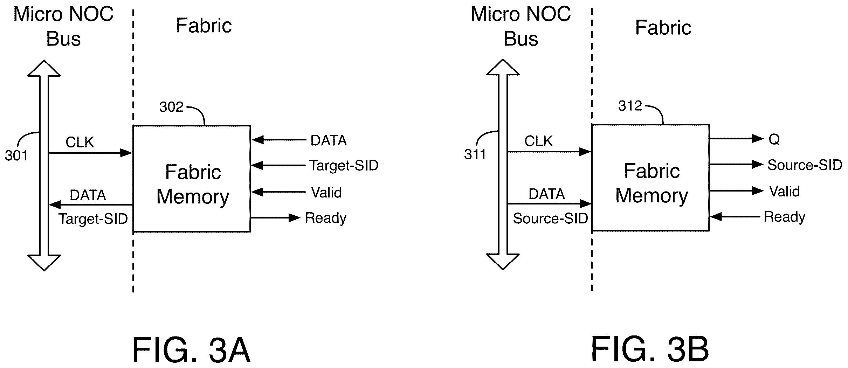

Figure 3A is a diagram that illustrates an example of a micro NOC ingress interface circuit that is mapped to an interface for a fabric memory circuit. FIG. 3A depicts a portion of a micro NOC bus 301 (e.g., a portion of one of micro NOCs 104) and a fabric memory circuit 302 in fabric region 103. In the direct ingress interface of FIG. 3A, DATA and Target-sink stream identifier (SID) values are provided to the fabric memory circuit 302. The fabric memory circuit 302 stores the DATA and the Target-sink SID values and provides the DATA and Target-sink SID values to the micro NOC bus 301. The fabric memory circuit 302 provides the DATA (e.g., as chunks of data) and the Target-sink SID values to micro NOC bus 301 using a clock signal CLK received from micro NOC bus 301. Each chunk of DATA can be marked as valid or not valid by the Valid signal. The DATA is transferred through micro NOC bus 301 in order to the target memory group having the stream identifier (SID) indicated by the Target-sink SID value. The fabric memory circuit 302 generates a Ready signal before the transaction begins to indicate that the memory is not full and has space for more data. If the sink is full, a stall is asserted on the micro-NOC. On the back side of the BRAM, writes are not allowed to the micro-NOC from the source. In some embodiments, the Target sink-SID values can be removed if the connection is point-to-point.

Figure 3B is a diagram that illustrates an example of a micro NOC egress interface circuit that is mapped to an interface for a fabric memory circuit. FIG. 3B depicts a portion of a micro NOC bus 311 (e.g., a portion of one of micro NOCs 104) and a fabric memory circuit 312 in fabric region 103. In the direct egress interface of FIG. 3B, data (referred to as DATA and Q in FIG. 3B) and Source-SID (stream identifier or SID) values are provided from micro NOC bus 311 to the fabric memory circuit 312 using a clock signal CLK. The data is transferred through micro NOC bus 311 in order from the source memory group having the stream identifier (SID) indicated by the source-SID. Fabric memory circuit 312 stores the data Q and the Source-SID values and provides the data Q and Source-SID values as outputs. Each chunk of the data Q can be marked as valid or not valid by the Valid signal generated by the fabric memory circuit 312. The Ready signal is generated before the transaction begins to indicate that the memory is not full and has space for more data. In some embodiments, the Source-SID values can be removed if the connection is point-to-point.

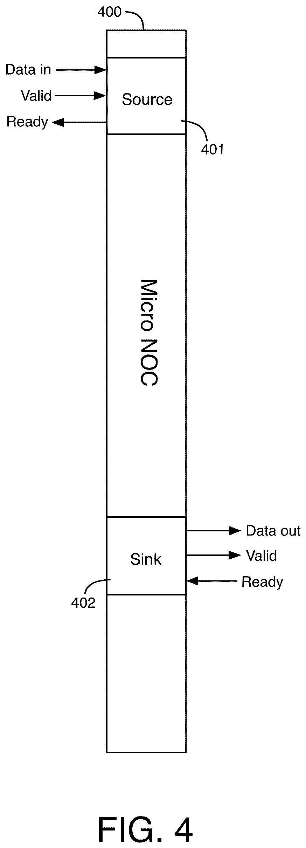

Figure 4 is a diagram that illustrates an example of a micro network-on-chip (NOC) 400 that is configured as a micro NOC direct coupling. Micro NOC 400 can be, for example, one or more of micro NOCs 104 of FIG. 1. Micro NOC 400 of FIG. 4 includes a source 401 and a sink 402 (e.g., each including one of memory circuits 201). FIG. 4 depicts a 1:1 source and sink implementation of a micro NOC direct coupling between source 401 and sink 402. The micro NOC direct coupling of FIG. 4 enables a micro NOC direct mode of operation that allows a micro NOC 400 that is not involved with a response buffer to operate as a vertical direct transport system.

The micro NOC direct coupling of FIG. 4 and the micro NOC direct mode of operation allow a user to create a first-in-first-out (FIFO) storage circuit over the micro NOC 400 that bypasses a response buffer in the IC. Data and a Valid value are provided as FIFO inputs to the source 401 from a first memory circuit in the fabric region 103. The micro NOC 400 transmits the Data to the sink 402, and the sink 402 outputs the Data and a Valid value as FIFO outputs to a second memory circuit in the fabric region 103. A Ready value is received at the sink 402 from the fabric region 103, and a Ready value is output at the source 401. The micro NOC 400 is configurable to place the source 401 and the sink 402 at any two of multiple locations (e.g., 4 or more locations) along the NOC 400. The micro NOC 400 is further configurable to place any source in micro NOC 400 receiving data from a first memory circuit and any sink in micro NOC 400 providing the data to a second memory circuit at any two of several locations along the NOC 400.

The micro NOC 400 is wide enough to transfer SID and data bits, and the depth of the micro NOC 400 can be several fabric memory circuits deep. With a single micro NOC direct coupling, the latency of the data transfer is deterministic and based on the distance between the source 401 and the sink 402. The sink 402 back-pressures when the sink is full.

A micro NOC direct coupling of a micro NOC can also be used in conjunction with response buffer (RB) partitions on the same micro NOC. The micro NOC bus can be split into a number of segments. The segments of the micro NOC allow the fabric region 103 to use the entire micro NOC bus, even when RB partitions do not extend to couple to each other. The micro NOC direct couplings can fully utilize segments of the micro NOC, while keeping the RB partitions, to effectively facilitate IC die-to-die communications.

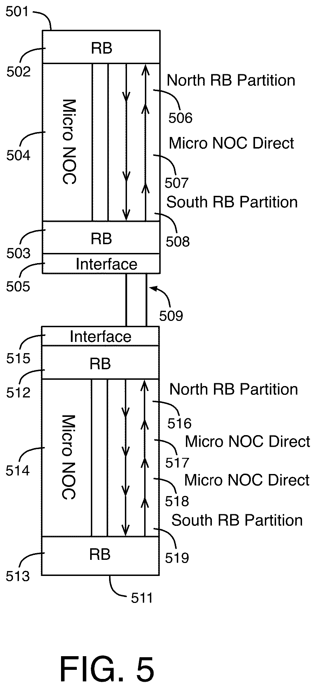

Figure 5 is a diagram that illustrates an example of two integrated circuit (IC) dies 501 and 511 that are coupled together through conductors 509 in an interface. The IC die 501 includes a micro NOC 504, an interface 505, and response buffer (RB) circuits 502-503. The micro NOC 504 includes north response buffer (RB) partition 506, micro NOC direct coupling segment 507, and south RB partition 508. The IC die 511 includes a micro NOC 514, an interface 515, and response buffer (RB) circuits 512-513. The micro NOC 514 includes north response buffer (RB) partition 516, micro NOC direct coupling segments 517-518, and south RB partition 519. The interfaces 505 and 515 can be, as examples, 2.5 or 3 dimensional die-to-die interfaces. Micro NOCs 504 and 514 can be, for example, two of micro NOCs 104 of FIG. 1.

The micro NOC direct coupling segment 507 of micro NOC 504 allows the fabric region of IC die 501 to transmit data through segment 507 between fabric memory circuits. The micro NOC direct coupling segments 517-518 of micro NOC 514 allow the fabric region of IC die 511 to transmit data between fabric memory circuits through segments 517 and 518, respectively. Segments 507, 517, and 518 allow for faster intra-segment data movement, because these segments enable data flow of a finer granularity. Data can be transmitted between IC die 501 and IC die 511 through the micro NOC 504 (e.g., through south RB partition 508), the RB circuit 503, the interface 505, conductors 509, interface 515, RB circuit 512, and micro NOC 514 (e.g., north RB partition 516).

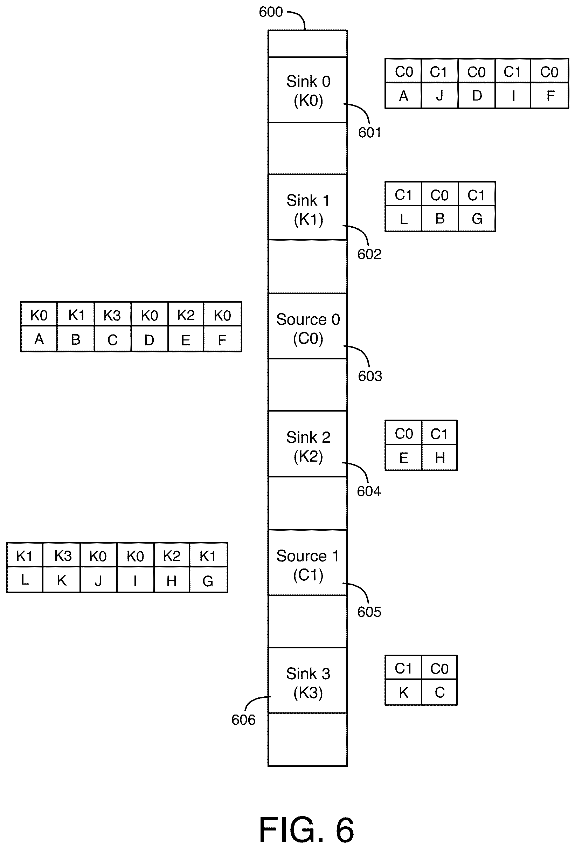

Figure 6 is a diagram that illustrates an example of a micro NOC 600 in an integrated circuit (IC) that allows a user to create a system of switches on top of a micro NOC column in a switch mode. Micro NOC 600 can be, for example, one or more of micro NOCs 104 of FIG. 1. In the example of FIG. 6, the micro NOC 600 includes Sink 0 (K0) 601, Sink 1 (K1) 602, Source 0 C0 603, Sink 2 (K2) 604, Source 1 (C1) 605, and Sink 3 (K3) 606. Each of the sources and sinks 601-606 in micro NOC 600 includes a memory circuit, such as one of the memory circuits 201A-201J of FIG. 2, that can store data transmitted through the micro NOC 600. Micro NOC 600 also includes conductors that couple together the memory circuits, as shown for example, in FIG. 2.

Figure 6 illustrates an example of how the micro NOC direct mode can be used to create switches in micro NOC 600. The switches can be created by tagging a source input with a sink output. When a source in the micro NOC sends data, the source also sends a tag that identifies the source. This architecture of the micro NOC 600 ensures that the data transmitted from a source to a sink arrives in order. When there are multiple sources transmitting data through micro NOC 600, the data can be interleaved. Each individual source data stream is transmitted through micro NOC 600 in order, which allows each sink to handle multiple data streams by checking the tags identifying the sources of the data streams. A deterministic bound on the latency of the transmitted data can be calculated, because the arbitration of the sources is fixed and known, and the distances between the sources and the sinks determines a cycle latency. The source and the sink are used as local arbiters to mix with other data traffic. The tags (e.g., SIDs) are only needed in the embodiment of FIG. 6 when multiple sources are transmitting to a sink and/or multiple sinks are receiving from a source in the switch use model.

Each column of a micro NOC can function as a switch having any desired width and length. As an example, the length of the switch may correspond to a bus length. For narrower widths, multiple switches can be formed in the micro NOC (e.g., 2 128 byte switches, 4 64 byte switches, 8 32 byte switches, etc.), because the micro NOC 600 is channelized. For the narrower widths, if the channels do not overlap, a user can create independent structures within micro NOC 600. Other allocations of the channels and SIDs can be used to create other structures within micro NOC 600.

In the example shown in FIG. 6, data chunks A, B, C, D, E, and F are initially stored in source C0 603 in micro NOC 600. The data chunks A, B, C, D, E, and F are then transmitted from source C0 603 through micro NOC 600 to sinks 601, 602, 606, 601, 604, and 601, respectively. The data chunks A, B, C, D, E, and F are transmitted through micro NOC 600 with stream identifiers (SIDs) K0, K1, K3, K0, K2, and K0 that identify the target sinks 601, 602, 606, 601, 604, and 601, respectively. The data chunks A, B, C, D, E, and F are also transmitted through micro NOC 600 with stream identifiers (SIDs) for source C0 603. After transmission through micro NOC 600, data chunks A, B, C, D, E, and F are stored in sinks 601, 602, 606, 601, 604, and 601, respectively, with the source identifier C0 identifying source 603, as shown in FIG. 6.

Also, in the example shown in FIG. 6, data chunks L, K, J, I, H, and G are initially stored in source C1 605 in micro NOC 600. The data chunks L, K, J, I, H, and G are then transmitted from source C1 605 through micro NOC 600 to sinks 602, 606, 601, 601, 604, and 602, respectively. The data chunks L, K, J, I, H, and G are transmitted through micro NOC 600 with stream identifiers (SIDs) K1, K3, K0, K0, K2, and K1 that identify the target sinks 602, 606, 601, 601, 604, and 602, respectively. The data chunks L, K, J, I, H, and G are also transmitted through micro NOC 600 with stream identifiers (SIDs) for source C1 605. After transmission through micro NOC 600, data chunks L, K, J, I, H, and G are stored in sinks 602, 606, 601, 601, 604, and 602, respectively, with the source identifier C1 identifying source 605, as shown in FIG. 6.

According to some examples, the micro NOCs disclosed herein, such as micro NOCs 104, 400, 504, 514, and 600, can include micro NOC controller circuits. The micro NOC controller circuits can be, for example, coupled to fabric memory circuits in the fabric region of an IC. In some examples, each of the memory circuits 201 of FIG. 2 can include a different one of the micro NOC controller circuits. The micro NOC controller circuits can be placed along a column of the micro NOC. The micro NOC controller circuits can accommodate micro NOC controller modes, as disclosed herein below. Each of the micro NOC controller modes is configured for different states. For example, each of the micro NOC controller circuits can be configured to function as a FIFO input and/or a FIFO output. As another example, each of the micro NOC controller circuits can be configured to transmit data in the north-bound direction or in the south-bound direction along the micro NOC.

According to some exemplary configurations of the micro NOC controller circuits, if only one source FIFO input is used, the full micro NOC bandwidth can be used to send the full data stream, and the micro NOC controller circuit reserves storage space for a single target sink identifier. If a user wants to use the switch mode, then less than the full bandwidth can be used for data, and the micro NOC controller circuit sends the source identifier as bits in the data stream. If a target sink stream identifier (SID) mode is used, then the target sink SID is embedded in the data and can be transmitted by transferring the target sink SID to the SID channel and making the source identifier part of the data.

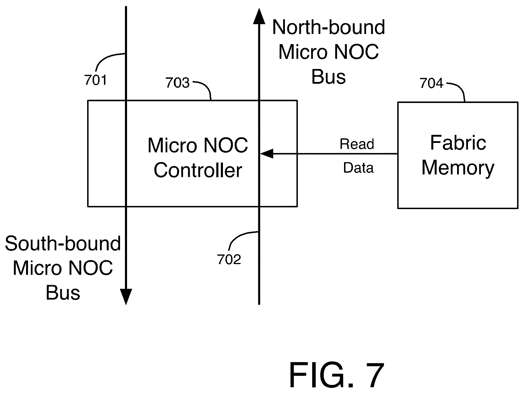

Figure 7 is a diagram that illustrates an example of a micro NOC controller circuit 703 in a micro NOC that is configured to read data from a fabric memory circuit 704 and to send the data read from the fabric memory circuit 704 along a north-bound micro NOC bus 702 in the micro NOC. The micro NOC of FIG. 7 can be, for example, one or more of micro NOCs 104 of FIG. 1 or any of the other micro NOCs disclosed herein, in a fabric region of an IC. The data is written to the fabric memory circuit 704 from another fabric memory circuit (not shown) using the Ready and Valid signals and the interface that are disclosed herein with respect to FIG. 3A. FIG. 7 shows a configuration for a source of a micro NOC direct transaction. The micro NOC of FIG. 7 also includes a south-bound micro NOC bus 701.

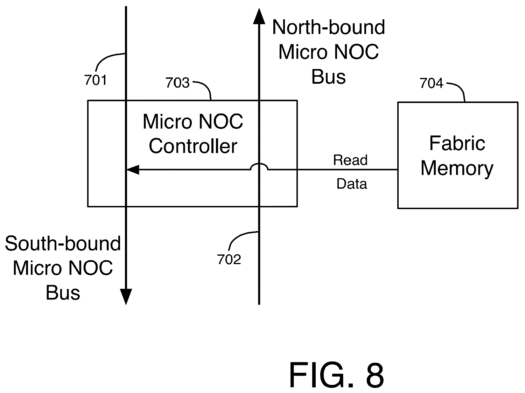

Figure 8 is a diagram that illustrates an example of the micro NOC controller circuit 703 in the micro NOC that is configured to read data from the fabric memory circuit 704 and to send the data read from the fabric memory circuit 704 along the south-bound micro NOC bus 701 in the micro NOC. The micro NOC of FIG. 8 can be, for example, one or more of micro NOCs 104 of FIG. 1 or any of the other micro NOCs disclosed herein, in a fabric region of an IC. The data is written to the fabric memory circuit 704 using the Ready and Valid signals and the interface that are disclosed herein with respect to FIG. 3A. FIG. 8 shows a configuration for a source of a micro NOC direct transaction.

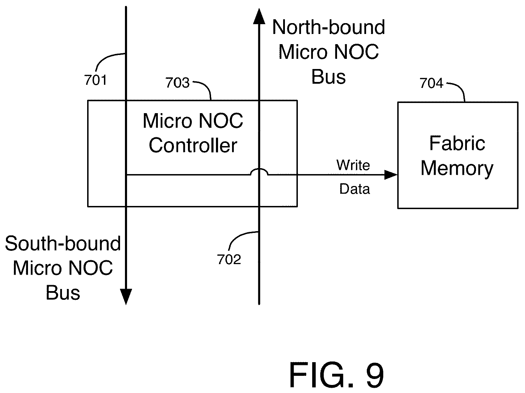

Figure 9 is a diagram that illustrates an example of the micro NOC controller circuit 703 in the micro NOC that is configured to transmit write data from the south-bound micro NOC bus 701 in the micro NOC to the fabric memory circuit 704. The write data is then written to the fabric memory circuit 704 using the Ready and Valid signals and the interface that are disclosed herein with respect to FIG. 3B. The micro NOC of FIG. 9 can be, for example, one or more of micro NOCs 104 of FIG. 1 or any of the other micro NOCs disclosed herein, in a fabric region of an IC. FIG. 9 shows a configuration for a sink of a micro NOC direct transaction.

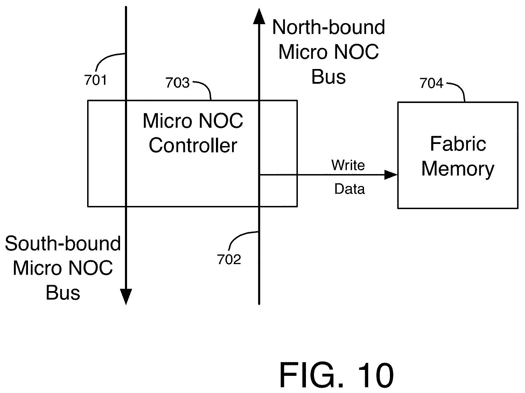

Figure 10 is a diagram that illustrates an example of the micro NOC controller circuit 703 in the micro NOC that is configured to transmit write data from the north-bound micro NOC bus 702 in the micro NOC to the fabric memory circuit 704. The write data is then written to the fabric memory circuit 704 using the Ready and Valid signals and the interface that are disclosed herein with respect to FIG. 3B. The micro NOC of FIG. 10 can be, for example, one or more of micro NOCs 104 of FIG. 1 or any of the other micro NOCs disclosed herein, in a fabric region of an IC. FIG. 10 shows a configuration for a sink of a micro NOC direct transaction.

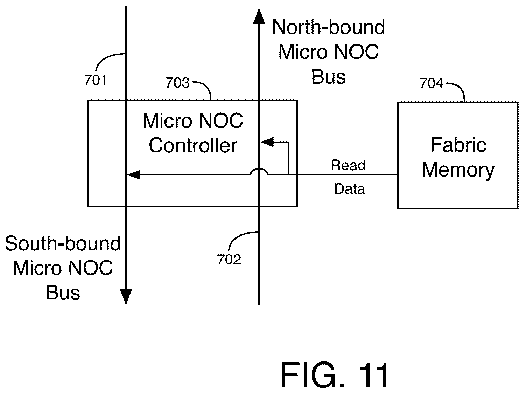

Figure 11 is a diagram that illustrates an example of the micro NOC controller circuit 703 in the micro NOC that is configured to read data from the fabric memory circuit 704 and to send the data read from the fabric memory circuit 704 along the north-bound micro NOC bus 702 and/or along the south-bound micro NOC bus 701 in the micro NOC. The micro NOC of FIG. 11 can be, for example, one or more of micro NOCs 104 of FIG. 1 or any of the other micro NOCs disclosed herein, in a fabric region of an IC. The data is written to the fabric memory circuit 704 using the Ready and Valid signals and the interface that are disclosed herein with respect to FIG. 3A. FIG. 11 shows a configuration for a source of a micro NOC direct transaction.

If software implements a late binding logical to physical address translation and orders the stream identifiers (SIDs) in monotonic order from the response buffer (RB) circuit, the micro NOC can determine if a read data packet should be transmitted through the north-bound micro NOC bus 702 or through the south-bound micro NOC bus 701 in the micro NOC. If this determination is not possible to make, the micro NOC controller circuit 703 can transmit the read data packet in both directions through the north-bound micro NOC bus 702 and through the south-bound micro NOC bus 701.

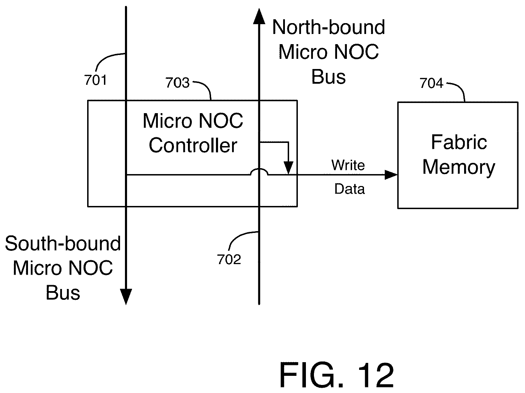

Figure 12 is a diagram that illustrates an example of the micro NOC controller circuit 703 in the micro NOC that is configured to transmit write data from the north-bound micro NOC bus 702 and/or from the south-bound micro NOC bus 701 in the micro NOC to the fabric memory circuit 704. If the write data is received from both the north-bound micro NOC bus 702 and from the south-bound micro NOC bus 701, the micro NOC controller circuit 703 performs arbitration and back-pressure to prevent data collisions. The write data is then written to the fabric memory circuit 704 using the Ready and Valid signals and the interface that are disclosed herein with respect to FIG. 3B. The micro NOC of FIG. 12 can be, for example, one or more of micro NOCs 104 of FIG. 1 or any of the other micro NOCs disclosed herein, in a fabric region of an IC. FIG. 12 shows a configuration for a sink of a micro NOC direct transaction.

To access the memory circuits in micro NOC direct mode, the following transactional flow can be performed. First, circuitry in the fabric region of the IC pushes data, a target sink identifier, and a data valid value using a Valid/Ready handshake. As long as the memory group is not full, the Ready signal is asserted. Second, when the micro NOC controller circuit 703 operates in turn based on arbitration, and there is no back-pressure, micro NOC controller circuit 703 outputs the data, a target sink identifier, and a data valid value and sends the data to the target using the data, a source identifier, and the data valid value as the payload and the target sink stream identifier as the SID.

If the target is either only above (e.g., north of) or below (e.g., south of) the source along the micro NOC, and the SIDs are assigned in order, the micro NOC controller circuit 703 only sends a command in one direction on the micro NOC based on the relative SID of the source from the target. If the relative position of the target is unknown or is known to be multicast in both directions (e.g., north-bound and south-bound in the micro NOC), the command is sent in both directions along the micro NOC.

The target in the micro NOC consumes the write data, the source identifier, and the data valid value matching the target sink identifier. The fabric region outputs the data, the source identifier, and data valid value using the Valid/Ready handshake. As long as the memory group is not empty, the Valid signal is asserted.

Figure 13 is a diagram of an illustrative example of a configurable integrated circuit (IC) 1300. Configurable IC 1300 is an example of an IC that can include the circuitry and micro NOCs disclosed herein with respect to Figures 1-12. As shown in FIG. 13, the configurable integrated circuit 1300 includes a two-dimensional array of configurable logic circuit blocks, including logic array blocks (LABs) 1310 and other configurable logic circuit blocks, such as random access memory (RAM) blocks 1330 and digital signal processing (DSP) blocks 1320, for example. Configurable logic circuit blocks, such as LABs 1310, can include smaller configurable regions (e.g., configurable logic elements, configurable logic blocks, or adaptive logic modules (ALMs)) that receive input signals and perform custom functions on the input signals to produce output signals.

The configurable integrated circuit 1300 also includes programmable interconnect circuitry in the form of vertical routing channels 1340 (i.e., interconnects formed along a vertical axis of configurable integrated circuit 1300) and horizontal routing channels 1350 (i.e., interconnects formed along a horizontal axis of configurable integrated circuit 1300), each routing channel including at least one track to route at least one wire. One or more of the routing channels 1340 and/or 1350 can be part of a network-on-chip (NOC) having router circuits.

In addition, the configurable integrated circuit 1300 has input/output elements (IOEs) 1302 for driving signals off of configurable integrated circuit 1300 and for receiving signals from other devices. Input/output elements 1302 can include parallel input/output circuitry, serial data transceiver circuitry, differential receiver and transmitter circuitry, or other circuitry used to connect one integrated circuit to another integrated circuit. Input/output elements 1302 can include general purpose input/output (GPIO) circuitry (e.g., on the top and bottoms edges of IC 1300), high-speed input/output (HSIO) circuitry (e.g., on the left edge of IC 1300), and on-package input/output (OPIOs) circuitry (e.g., on the right edge of IC 1300).

As shown, input/output elements 1302 can be located around the periphery of the IC. If desired, the configurable integrated circuit 1300 can have input/output elements 1302 arranged in different ways. For example, input/output elements 1302 can form one or more columns of input/output elements that can be located anywhere on the configurable integrated circuit 1300 (e.g., distributed evenly across the width of the configurable integrated circuit). If desired, input/output elements 1302 can form one or more rows of input/output elements (e.g., distributed across the height of the configurable integrated circuit). Alternatively, input/output elements 1302 can form islands of input/output elements that can be distributed over the surface of the configurable integrated circuit 1300 or clustered in selected areas.

Note that other routing topologies, besides the topology of the interconnect circuitry depicted in FIG. 13, can be used. For example, the routing topology can include wires that travel diagonally or that travel horizontally and vertically along different parts of their extent as well as wires that are perpendicular to the device plane in the case of three dimensional integrated circuits, and the driver of a wire can be located at a different point than one end of a wire. The routing topology can include global wires that span substantially all of configurable integrated circuit 1300, fractional global wires such as wires that span part of configurable integrated circuit 1300, staggered wires of a particular length, smaller local wires, or any other suitable interconnection resource arrangement.

Furthermore, it should be understood that examples disclosed herein may be implemented in any type of integrated circuit. If desired, the functional blocks of such an integrated circuit can be arranged in more levels or layers in which multiple functional blocks are interconnected to form still larger blocks. Other device arrangements can use functional blocks that are not arranged in rows and columns.

Configurable integrated circuit 1300 can also contain programmable memory elements. The memory elements can be loaded with configuration data (also called programming data) using input/output elements (IOEs) 1302. Once loaded, the memory elements each provide a corresponding static control signal that controls the operation of an associated functional block (e.g., LABs 1310, DSP 1320, RAM 1330, or input/output elements 1302).

In a typical scenario, the outputs of the loaded memory elements are applied to the gates of field-effect transistors in a functional block to turn certain transistors on or off and thereby configure the logic in the functional block including the routing paths. Programmable logic circuit elements that are controlled in this way include parts of multiplexers (e.g., multiplexers used for forming routing paths in interconnect circuits), look-up tables, logic arrays, AND, OR, NAND, and NOR logic gates, pass gates, etc.

The memory elements can use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data during programming, the memory elements are sometimes referred to as configuration memory or programmable memory elements.

The programmable memory elements can be organized in a configuration memory array consisting of rows and columns. A data register that spans across all columns and an address register that spans across all rows can receive configuration data. The configuration data can be shifted onto the data register. When the appropriate address register is asserted, the data register writes the configuration data to the configuration memory elements of the row that was designated by the address register.

Configurable integrated circuit 1300 can include configuration memory that is organized in sectors, whereby a sector can include the configuration bits that specify the function and/or interconnections of the subcomponents and wires in or crossing that sector. Each sector can include separate data and address registers.

The configurable IC 1300 of FIG. 13 is merely one example of an IC that can be used with embodiments disclosed herein. The embodiments disclosed herein can be used with any suitable electronic integrated circuit or system. For example, the embodiments disclosed herein can be used with numerous types of electronic devices such as processor integrated circuits, central processing units, memory integrated circuits, graphics processing unit integrated circuits, application specific standard products (ASSPs), application specific integrated circuits (ASICs), and configurable logic integrated circuits. Examples of configurable logic integrated circuits include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The integrated circuits disclosed in one or more embodiments herein can be part of a data processing system that includes one or more of the following components: a processor; memory; input/output circuitry; and peripheral devices. The data processing system can be used in a wide variety of applications, such as computer networking, data networking, instrumentation, video processing, digital signal processing, or any suitable other application. The integrated circuits can be used to perform a variety of different logic functions.

In general, software and data for performing any of the functions disclosed herein can be stored in non-transitory computer readable storage media. Non-transitory computer readable storage media is tangible computer readable storage media that stores data and software for access at a later time, as opposed to media that only transmits propagating electrical signals (e.g., wires). The software code may sometimes be referred to as software, data, program instructions, instructions, or code. The non-transitory computer readable storage media can, for example, include computer memory chips, non-volatile memory such as non-volatile random-access memory (NVRAM), one or more hard drives (e.g., magnetic drives or solid state drives), one or more removable flash drives or other removable media, compact discs (CDs), digital versatile discs (DVDs), Blu-ray discs (BDs), other optical media, and floppy diskettes, tapes, or any other suitable memory or storage device(s).

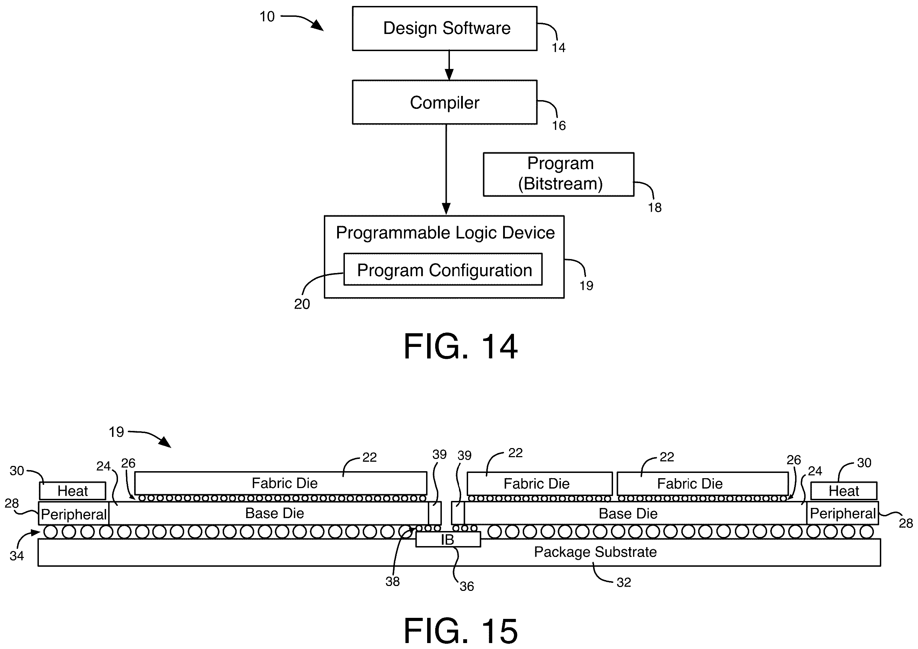

Figure 14 illustrates a block diagram of a system 10 that can be used to implement a circuit design to be programmed onto a programmable logic device 19 using design software. A designer can implement circuit design functionality on an integrated circuit, such as a reconfigurable programmable logic device 19 (e.g., a field programmable gate array (FPGA)). The designer can implement the circuit design to be programmed onto the programmable logic device 19 using design software 14. The design software 14 can use a compiler 16 to generate a low-level circuit-design program (bitstream) 18, sometimes known as a program object file and/or configuration program, that programs the programmable logic device 19. Thus, the compiler 16 can provide machine-readable instructions representative of the circuit design to the programmable logic device 19. For example, the programmable logic device 19 can receive one or more programs (bitstreams) 18 that describe the hardware implementations that should be stored in the programmable logic device 19. A program (bitstream) 18 can be programmed into the programmable logic device 19 as a configuration program 20. The configuration program 20 can, in some cases, represent an accelerator function to perform for machine learning, video processing, voice recognition, image recognition, or other highly specialized task.

In some implementations, a programmable logic device can be any integrated circuit device that includes a programmable logic device with two separate integrated circuit die where at least some of the programmable logic fabric is separated from at least some of the fabric support circuitry that operates the programmable logic fabric. One example of such a programmable logic device is shown in FIG. 15, but many others can be used, and it should be understood that this disclosure is intended to encompass any suitable programmable logic device where programmable logic fabric and fabric support circuitry are at least partially separated on different integrated circuit die.

Figure 15 is a diagram that depicts an example of the programmable logic device 19 that includes three fabric die 22 and two base die 24 that are connected to one another via microbumps 26. In the example of FIG. 15, at least some of the programmable logic fabric of the programmable logic device 19 is in the three fabric die 22, and at least some of the fabric support circuitry that operates the programmable logic fabric is in the two base die 24. For example, some of the circuitry of configurable IC 1300 shown in FIG. 13 (e.g., LABs 1310, DSP 1320, and RAM 1330) can be located in the fabric die 22 and some of the circuitry of IC 1300 (e.g., input/output elements 1302) can be located in the base die 24.

Although the fabric die 22 and base die 24 appear in a one-to-one relationship or a two-to-one relationship in FIG. 15, other relationships can be used. For example, a single base die 24 can attach to several fabric die 22, or several base die 24 can attach to a single fabric die 22, or several base die 24 can attach to several fabric die 22 (e.g., in an interleaved pattern). Peripheral circuitry 28 can be attached to, embedded within, and/or disposed on top of the base die 24, and heat spreaders 30 can be used to reduce an accumulation of heat on the programmable logic device 19. The heat spreaders 30 can appear above, as pictured, and/or below the package (e.g., as a double-sided heat sink). The base die 24 can attach to a package substrate 32 via conductive bumps 34. In the example of FIG. 15, two pairs of fabric die 22 and base die 24 are shown communicatively connected to one another via an interconnect bridge 36 (e.g., an embedded multi-die interconnect bridge (EMIB)) and microbumps 38 at bridge interfaces 39 in base die 24.

In combination, the fabric die 22 and the base die 24 can operate in combination as a programmable logic device 19 such as a field programmable gate array (FPGA). It should be understood that an FPGA can, for example, represent the type of circuitry, and/or a logical arrangement, of a programmable logic device when both the fabric die 22 and the base die 24 operate in combination. Moreover, an FPGA is discussed herein for the purposes of this example, though it should be understood that any suitable type of programmable logic device can be used.

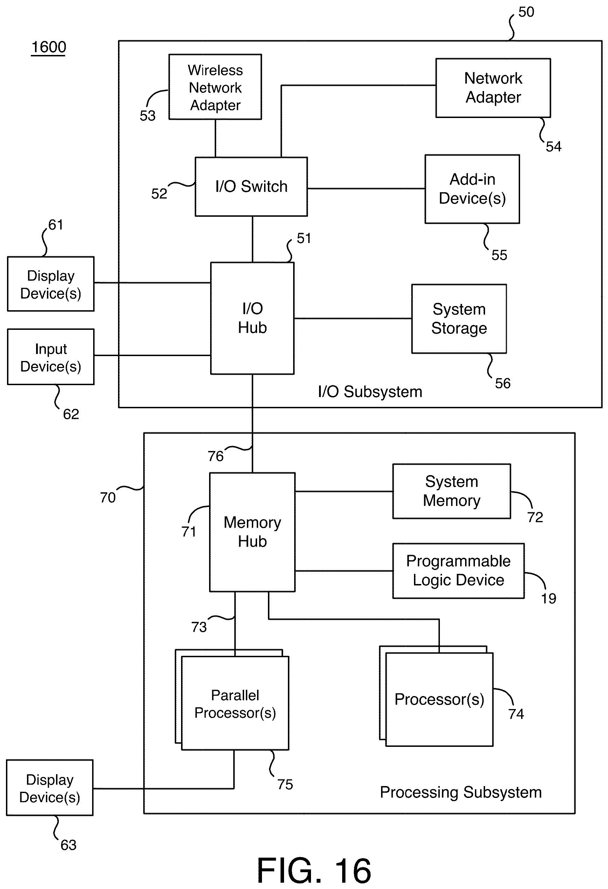

Figure 16 is a block diagram illustrating a computing system 1600 configured to implement one or more aspects of the embodiments described herein. The computing system 1600 includes a processing subsystem 70 having one or more processor(s) 74, a system memory 72, and a programmable logic device 19 communicating via an interconnection path that can include a memory hub 71. The memory hub 71 can be a separate component within a chipset component or can be integrated within the one or more processor(s) 74. The memory hub 71 couples with an input/output (I/O) subsystem 50 via a communication link 76. The I/O subsystem 50 includes an input/output (I/O) hub 51 that can enable the computing system 1600 to receive input from one or more input device(s) 62. Additionally, the I/O hub 51 can enable a display controller, which can be included in the one or more processor(s) 74, to provide outputs to one or more display device(s) 61. In one embodiment, the one or more display device(s) 61 coupled with the I/O hub 51 can include a local, internal, or embedded display device.

In one embodiment, the processing subsystem 70 includes one or more parallel processor(s) 75 coupled to memory hub 71 via a bus or other communication link 73. The communication link 73 can use one of any number of standards based communication link technologies or protocols, such as, but not limited to, PCI Express, or can be a vendor specific communications interface or communications fabric. In one embodiment, the one or more parallel processor(s) 75 form a computationally focused parallel or vector processing system that can include a large number of processing cores and/or processing clusters, such as a many integrated core (MIC) processor. In one embodiment, the one or more parallel processor(s) 75 form a graphics processing subsystem that can output pixels to one of the one or more display device(s) 61 coupled via the I/O Hub 51. The one or more parallel processor(s) 75 can also include a display controller and display interface (not shown) to enable a direct connection to one or more display device(s) 63.

Within the I/O subsystem 50, a system storage unit 56 can connect to the I/O hub 51 to provide a storage mechanism for the computing system 1600. An I/O switch 52 can be used to provide an interface mechanism to enable connections between the I/O hub 51 and other components, such as a network adapter 54 and/or a wireless network adapter 53 that can be integrated into the platform, and various other devices that can be added via one or more add-in device(s) 55. The network adapter 54 can be an Ethernet adapter or another wired network adapter. The wireless network adapter 53 can include one or more of a Wi-Fi, Bluetooth, near field communication (NFC), or other network device that includes one or more wireless radios.

The computing system 1600 can include other components not shown in FIG. 16, including other port connections, optical storage drives, video capture devices, and the like, that can also be connected to the I/O hub 51. Communication paths interconnecting the various components in FIG. 16 can be implemented using any suitable protocols, such as PCI (Peripheral Component Interconnect) based protocols (e.g., PCI-Express), or any other bus or point-to-point communication interfaces and/or protocol(s), such as the NV-Link high-speed interconnect, or interconnect protocols known in the art.

In one embodiment, the one or more parallel processor(s) 75 incorporate circuitry optimized for graphics and video processing, including, for example, video output circuitry, and constitutes a graphics processing unit (GPU). In another embodiment, the one or more parallel processor(s) 75 incorporate circuitry optimized for general purpose processing, while preserving the underlying computational architecture. In yet another embodiment, components of the computing system 1600 can be integrated with one or more other system elements on a single integrated circuit. For example, the one or more parallel processor(s) 75, memory hub 71, processor(s) 74, and I/O hub 51 can be integrated into a system on chip (SoC) integrated circuit. Alternatively, the components of the computing system 1600 can be integrated into a single package to form a system in package (SIP) configuration. In one embodiment, at least a portion of the components of the computing system 1600 can be integrated into a multi-chip module (MCM), which can be interconnected with other multi-chip modules into a modular computing system.

The computing system 1600 shown herein is illustrative. Other variations and modifications are also possible. The connection topology, including the number and arrangement of bridges, the number of processor(s) 74, and the number of parallel processor(s) 75, can be modified as desired. For instance, in some embodiments, system memory 72 is connected to the processor(s) 74 directly rather than through a bridge, while other devices communicate with system memory 72 via the memory hub 71 and the processor(s) 74. In other alternative topologies, the parallel processor(s) 75 are connected to the I/O hub 51 or directly to one of the one or more processor(s) 74, rather than to the memory hub 71. In other embodiments, the I/O hub 51 and memory hub 71 can be integrated into a single chip. Some embodiments can include two or more sets of processor(s) 74 attached via multiple sockets, which can couple with two or more instances of the parallel processor(s) 75.

Some of the particular components shown herein are optional and may not be included in all implementations of the computing system 1600. For example, any number of add-in cards or peripherals can be supported, or some components can be eliminated. Furthermore, some architectures can use different terminology for components similar to those illustrated in FIG. 16. For example, the memory hub 71 can be referred to as a Northbridge in some architectures, while the I/O hub 51 can be referred to as a Southbridge.

Additional examples are now described. Example 1 is an integrated circuit comprising: first memory circuits in a central region of the integrated circuit; and a first network-on-chip that traverses the central region, wherein the first network-on-chip comprises a first controller circuit configurable to exchange first data between first and second ones of the first memory circuits through the first network-on-chip by transmitting the first data from a first source in the first network-on-chip to a first sink in the first network-on-chip, and wherein the first network-on-chip is configurable to place each of the first source and the first sink at one of multiple locations along the first network-on-chip.

In Example 2, the integrated circuit of Example 1 can optionally include, wherein the first network-on-chip further comprises second memory circuits configurable to store the first data transmitted through the first network-on-chip.

In Example 3, the integrated circuit of any one of Examples 1-2 can optionally include, wherein the first network-on-chip is configurable to transmit a source identifier identifying the first one of the first memory circuits and a sink identifier identifying the second one of the first memory circuits with the first data, and wherein the first network-on-chip receives the first data from the first one of the first memory circuits and transmits the first data to the second one of the first memory circuits.

In Example 4, the integrated circuit of any one of Examples 1-3 can optionally include, wherein the first network-on-chip is configurable to transmit the first data through a first segment of the first network-on-chip between the first and the second ones of the first memory circuits, and wherein the first network-on-chip is further configurable to transmit second data through a second segment of the first network-on-chip between third and fourth ones of the first memory circuits.

In Example 5, the integrated circuit of any one of Examples 1-4 can optionally include, wherein the first controller circuit is further configurable to transmit second data through the first-network-on-chip from the first one of the first memory circuits to a third one of the first memory circuits.

In Example 6, the integrated circuit of Example 5 can optionally include, wherein the first controller circuit is further configurable to transmit the second data between the first and the third ones of the first memory circuits through the first network-on-chip by transmitting the second data from the first source in the first network-on-chip to a second sink in the first network-on-chip, and wherein the first network-on-chip is configurable to place each of the first source and the second sink at one of multiple locations along the first network-on-chip.

In Example 7, the integrated circuit of any one of Examples 1-6 can optionally include, wherein the first controller circuit is further configurable to exchange second data between third and fourth ones of the first memory circuits through the first network-on-chip by transmitting the second data from a second source in the first network-on-chip to a second sink in the first network-on-chip, and wherein the first network-on-chip is configurable to place each of the second source and the second sink at one of multiple locations along the first network-on-chip.

In Example 8, the integrated circuit of any one of Examples 1-7 further comprises a second network-on-chip that surrounds the central region, wherein the first controller circuit is configurable to transmit the first data through the first network-on-chip between the first and the second ones of the first memory circuits without routing the first data through the second network-on-chip.

In Example 9, the integrated circuit of any one of Examples 1-8 further comprises second memory circuits in the central region of the integrated circuit; and a second network-on-chip that traverses the central region, wherein the second network-on-chip comprises a second controller circuit configurable to exchange second data through the second network-on-chip between the second memory circuits by transmitting the second data from a second source in the second network-on-chip to a second sink in the second network-on-chip, and wherein the second network-on-chip is configurable to place the second source and the second sink at two of at least four locations along the second network-on-chip.

Example 10 is a method for transmitting first data through a network-on-chip in an integrated circuit, the method comprising: receiving the first data and a first identifier from a first memory circuit at a first source in the network-on-chip, wherein the first identifier identifies a second memory circuit, wherein the network-on-chip extends across a length of a fabric region of the integrated circuit, and wherein the first and the second memory circuits are in the fabric region; transmitting the first data and a second identifier that identifies the first memory circuit through a first bus in the network-on-chip from the first source to a first sink in the network-on-chip using a controller circuit in the network-on-chip based on the first identifier, wherein the network-on-chip is configurable to locate each of the first source and the first sink at one of multiple locations in the network-on-chip; and providing the first data from the first sink to the second memory circuit.

In Example 11, the method of Example 10 further comprises: receiving second data and a third identifier from the first memory circuit at the first source, wherein the third identifier identifies a third memory circuit, and wherein the third memory circuit is in the fabric region; transmitting the second data and the second identifier through a second bus in the network-on-chip from the first source to a second sink in the network-on-chip using the controller circuit based on the third identifier; and providing the second data from the second sink to the third memory circuit.

In Example 12, the method of any one of Examples 10-11 further comprises: receiving second data and the first identifier from a third memory circuit at a second source, wherein a third identifier identifies the third memory circuit, and wherein the third memory circuit is in the fabric region; and transmitting the second data and the third identifier through a second bus in the network-on-chip from the second source to the first sink in the network-on-chip using the controller circuit based on the first identifier; and providing the second data from the first sink to the second memory circuit.

In Example 13, the method of any one of Examples 10-12 further comprises: transmitting second data through a first segment of the network-on-chip between third and fourth memory circuits in the fabric region using the controller circuit based on a third identifier, wherein the network-on-chip transmits the first data and the second identifier through a second segment of the network-on-chip between the first and the second memory circuits using the controller circuit.

In Example 14, the method of any one of Examples 10-13 may optionally include, wherein transmitting the first data and the second identifier through the first bus in the network-on-chip further comprises creating a first-in-first-out (FIFO) storage circuit over the network-on-chip that bypasses a response buffer in the integrated circuit, wherein the first data and a valid value are provided as FIFO inputs to the first memory circuit.

In Example 15, the method of Example 14 further comprises: transmitting the first data and the valid value to the second memory circuit; and outputting the first data and the valid value as FIFO outputs from the second memory circuit.

Example 16 is a configurable integrated circuit comprising: a fabric region comprising memory circuits, programmable logic circuits, and a first network-on-chip that extends across a length of the fabric region, wherein the first network-on-chip comprises a first controller circuit configurable to transmit first data between a first one of the memory circuits and a second one of the memory circuits by providing the first data from a first source in the first network-on-chip to a first sink in the first network-on-chip, and wherein the first network-on-chip is configurable to place the first source and the first sink at two of at least four different positions in the first network-on-chip.

In Example 17, the configurable integrated circuit of Example 16 can optionally include, wherein the fabric region further comprises a second network-on-chip that extends across the length of the fabric region, and wherein the second network-on-chip comprises a second controller circuit configurable to transmit second data between a third one of the memory circuits and a fourth one of the memory circuits by providing the second data from a second source in the second network-on-chip to a second sink in the second network-on-chip, and wherein the second network-on-chip is configurable to place each of the second source and the second sink at one of multiple locations in the second network-on-chip.

In Example 18, the configurable integrated circuit of any one of Examples 16-17 can optionally include, wherein the first controller circuit is further configurable to transmit second data through the first network-on-chip between a third one of the memory circuits and the second one of the memory circuits by providing the second data from a second source in the first network-on-chip to the first sink in the first network-on-chip, and wherein the first network-on-chip is configurable to place each of the second source and the first sink at one of multiple locations in the first network-on-chip.

In Example 19, the configurable integrated circuit of Example 18 can optionally include, wherein the first controller circuit is further configurable to transmit a first source identifier identifying the second one of the memory circuits and a second source identifier identifying the third one of the memory circuits, and wherein the first network-on-chip provides the second source identifier to the second one of the memory circuits.

In Example 20, the configurable integrated circuit of any one of Examples 16-19 can optionally include, wherein the first network-on-chip is configurable to transmit the first data through a first segment of the first network-on-chip between the first source and the first sink, wherein the first network-on-chip is further configurable to transmit second data through a second segment of the first network-on-chip between a second source and a second sink, and wherein the first network-on-chip is configurable to place the second source and the second sink at two of the at least four different positions in the first network-on-chip.

The foregoing description of the exemplary embodiments has been presented for the purpose of illustration. The foregoing description is not intended to be exhaustive or to be limiting to the examples disclosed herein. The foregoing is merely illustrative of the principles of this disclosure and various modifications can be made by those skilled in the art. The foregoing embodiments may be implemented individually or in any combination.

## Claims

1. An integrated circuit comprising:
first memory circuits in a central region of the integrated circuit; and
a first network-on-chip that traverses the central region, wherein the first network-on-chip comprises a first controller circuit configurable to exchange first data between first and second ones of the first memory circuits through the first network-on-chip by transmitting the first data from a first source in the first network-on-chip to a first sink in the first network-on-chip, and wherein the first network-on-chip is configurable to place each of the first source and the first sink at one of multiple locations along the first network-on-chip.

2. The integrated circuit of claim 1, wherein the first network-on-chip further comprises second memory circuits configurable to store the first data transmitted through the first network-on-chip.

3. The integrated circuit of claim 1 or 2, wherein the first network-on-chip is configurable to transmit a source identifier identifying the first one of the first memory circuits and a sink identifier identifying the second one of the first memory circuits with the first data, and wherein the first network-on-chip receives the first data from the first one of the first memory circuits and transmits the first data to the second one of the first memory circuits.

4. The integrated circuit of one of claims 1 to 3, wherein the first network-on-chip is configurable to transmit the first data through a first segment of the first network-on-chip between the first and the second ones of the first memory circuits, and wherein the first network-on-chip is further configurable to transmit second data through a second segment of the first network-on-chip between third and fourth ones of the first memory circuits.

5. The integrated circuit of one of claims 1 to 4, wherein the first controller circuit is further configurable to transmit second data through the first-network-on-chip from the first one of the first memory circuits to a third one of the first memory circuits.

6. The integrated circuit of claim 5, wherein the first controller circuit is further configurable to transmit the second data between the first and the third ones of the first memory circuits through the first network-on-chip by transmitting the second data from the first source in the first network-on-chip to a second sink in the first network-on-chip, and wherein the first network-on-chip is configurable to place each of the first source and the second sink at one of multiple locations along the first network-on-chip.

7. The integrated circuit of one of claims 1 to 6, wherein the first controller circuit is further configurable to exchange second data between third and fourth ones of the first memory circuits through the first network-on-chip by transmitting the second data from a second source in the first network-on-chip to a second sink in the first network-on-chip, and wherein the first network-on-chip is configurable to place each of the second source and the second sink at one of multiple locations along the first network-on-chip.

8. The integrated circuit of one of claims 1 to 7 further comprising:
a second network-on-chip that surrounds the central region, wherein the first controller circuit is configurable to transmit the first data through the first network-on-chip between the first and the second ones of the first memory circuits without routing the first data through the second network-on-chip.

9. The integrated circuit of one of claims 1 to 8 further comprising:
second memory circuits in the central region of the integrated circuit; and
a second network-on-chip that traverses the central region, wherein the second network-on-chip comprises a second controller circuit configurable to exchange second data through the second network-on-chip between the second memory circuits by transmitting the second data from a second source in the second network-on-chip to a second sink in the second network-on-chip, and wherein the second network-on-chip is configurable to place the second source and the second sink at two of at least four locations along the second network-on-chip.

10. A method for transmitting first data through a network-on-chip in an integrated circuit, the method comprising:
receiving the first data and a first identifier from a first memory circuit at a first source in the network-on-chip, wherein the first identifier identifies a second memory circuit, wherein the network-on-chip extends across a length of a fabric region of the integrated circuit, and wherein the first and the second memory circuits are in the fabric region;
transmitting the first data and a second identifier that identifies the first memory circuit through a first bus in the network-on-chip from the first source to a first sink in the network-on-chip using a controller circuit in the network-on-chip based on the first identifier, wherein the network-on-chip is configurable to locate each of the first source and the first sink at one of multiple locations in the network-on-chip; and
providing the first data from the first sink to the second memory circuit.

11. The method of claim 10 further comprising:
receiving second data and a third identifier from the first memory circuit at the first source, wherein the third identifier identifies a third memory circuit, and wherein the third memory circuit is in the fabric region;
transmitting the second data and the second identifier through a second bus in the network-on-chip from the first source to a second sink in the network-on-chip using the controller circuit based on the third identifier; and
providing the second data from the second sink to the third memory circuit; and/or
the method further comprising:
receiving second data and the first identifier from a third memory circuit at a second source, wherein a third identifier identifies the third memory circuit, and wherein the third memory circuit is in the fabric region;
transmitting the second data and the third identifier through a second bus in the network-on-chip from the second source to the first sink in the network-on-chip using the controller circuit based on the first identifier; and
providing the second data from the first sink to the second memory circuit; and/or
the method further comprising:
transmitting second data through a first segment of the network-on-chip between third and fourth memory circuits in the fabric region using the controller circuit based on a third identifier,
wherein the network-on-chip transmits the first data and the second identifier through a second segment of the network-on-chip between the first and the second memory circuits using the controller circuit.

12. The method of claim 10 or 11, wherein transmitting the first data and the second identifier through the first bus in the network-on-chip further comprises creating a first-in-first-out (FIFO) storage circuit over the network-on-chip that bypasses a response buffer in the integrated circuit, wherein the first data and a valid value are provided as FIFO inputs to the first memory circuit, wherein, preferably, the method further comprises:
transmitting the first data and the valid value to the second memory circuit; and
outputting the first data and the valid value as FIFO outputs from the second memory circuit.

13. A configurable integrated circuit comprising:
a fabric region comprising memory circuits, programmable logic circuits, and a first network-on-chip that extends across a length of the fabric region, wherein the first network-on-chip comprises a first controller circuit configurable to transmit first data between a first one of the memory circuits and a second one of the memory circuits by providing the first data from a first source in the first network-on-chip to a first sink in the first network-on-chip, and wherein the first network-on-chip is configurable to place the first source and the first sink at two of at least four different positions in the first network-on-chip.

14. The configurable integrated circuit of claim 13, wherein the fabric region further comprises a second network-on-chip that extends across the length of the fabric region, and wherein the second network-on-chip comprises a second controller circuit configurable to transmit second data between a third one of the memory circuits and a fourth one of the memory circuits by providing the second data from a second source in the second network-on-chip to a second sink in the second network-on-chip, and wherein the second network-on-chip is configurable to place each of the second source and the second sink at one of multiple locations in the second network-on-chip.

15. The configurable integrated circuit of claim 13 or 14, wherein the first controller circuit is further configurable to transmit second data through the first network-on-chip between a third one of the memory circuits and the second one of the memory circuits by providing the second data from a second source in the first network-on-chip to the first sink in the first network-on-chip, and wherein the first network-on-chip is configurable to place each of the second source and the first sink at one of multiple locations in the first network-on-chip, and preferably, wherein the first controller circuit is further configurable to transmit a first source identifier identifying the second one of the memory circuits and a second source identifier identifying the third one of the memory circuits, and wherein the first network-on-chip provides the second source identifier to the second one of the memory circuits; and/or
wherein the first network-on-chip is configurable to transmit the first data through a first segment of the first network-on-chip between the first source and the first sink, wherein the first network-on-chip is further configurable to transmit second data through a second segment of the first network-on-chip between a second source and a second sink, and wherein the first network-on-chip is configurable to place the second source and the second sink at two of the at least four different positions in the first network-on-chip.
